# EUROPEAN PATENT APPLICATION

(11) **EP 3 136 452 A1**
(43) Date of publication of application: **01.03.2017**
(21) Application number: 15782566.2
(22) Date of filing: 02.04.2015
(51) Int. Cl.: H01L 33/50, C04B 35/50, C04B 35/622, C04B 41/87

(54) **WAVELENGTH CONVERSION MEMBER AND METHOD FOR MANUFACTURING SAME**

(30) Priority: 23.04.2014 JP 2014089576; 27.02.2015 JP 2015039034
(71) Applicant: Nitto Denko Corporation, Ibaraki-shi, Osaka 567-8680 (JP)
(72) Inventor: SHIRAKAWA, Masahiro, Ibaraki-shi, Osaka 567-8680 (JP); FUJII, Hironaka, Ibaraki-shi, Osaka 567-8680 (JP)
(74) Representative: Hoffmann Eitle
(86) International application number: PCT/JP2015/060517
(87) International publication number: WO 2015/163109

(57) **Abstract**

A method for producing a wavelength conversion member includes disposing a phosphor ceramic layer on a substrate; removing a portion of the phosphor ceramic layer so that a plurality of phosphor ceramic elements are disposed in a direction perpendicular to the thickness direction of the substrate in spaced-apart relation; forming a cover layer containing an inorganic substance on the substrate so as to cover the surface of the phosphor ceramic element; and cutting the cover layer and the substrate in the thickness direction so as to include at least one of the phosphor ceramic elements.

## Description

### TECHNICAL FIELD

The present invention relates to a wavelength conversion member and a production method thereof; in particular, the present invention relates to a method for producing a wavelength conversion member, and a wavelength conversion member produced by the method.

### BACKGROUND ART

A light-emitting diode device generally includes an LED (light-emitting diode element) that is mounted on the surface of a substrate and emits blue light, a phosphor layer that can convert the blue light to yellow light and is provided on the LED, and an encapsulating layer that encapsulates the LED. Such a light-emitting diode device emits white light by color mixture of blue light emitted from the LED encapsulated by the encapsulating layer and penetrating the phosphor layer, and yellow light produced by converting the wavelength of a portion of the blue light at the phosphor layer.

Patent Document 1 (ref: below) has proposed, as a method for producing such a light-emitting diode device, the following method.

That is, first, a recess portion is provided in a transparent encapsulating layer, and a curable phosphor composition is introduced into the recess portion by potting and is cured to produce a wavelength conversion sheet including the transparent encapsulating layer and a phosphor layer, and then an LED is embedded in the surface of the phosphor layer of the wavelength conversion sheet.

### Citation List

### Patent Document

Patent Document 1 Japanese Unexamined Patent Publication No. 2013-187227

### [SUMMARY OF THE INVENTION]

### PROBLEM TO BE SOLVED BY THE INVENTION

However, in semiconductor light-emitting devices such as light-emitting diode devices and semiconductor laser devices, a high power (high output) light source is sometimes provided. When the wavelength of such a high power light is converted with the wavelength conversion sheet, high heat resistance is required for the wavelength conversion sheet. Thus, use of phosphor ceramics with excellent heat resistance in a wavelength conversion sheet has been examined.

However, for phosphor ceramics, phosphor is sintered at a high temperature (e.g., 1000°C or more), and therefore there are disadvantages such as the following: unlike the above-described method of Patent Document 1, the formation cannot be done by potting the phosphor composition and curing.

An object of the present invention is to provide a method for producing a wavelength conversion member easily and industrially, and a wavelength conversion member produced by the method and having excellent heat resistance.

### MEANS FOR SOLVING THE PROBLEM

A method for producing a wavelength conversion member of the present invention includes disposing a phosphor ceramic layer on a substrate; removing a portion of the phosphor ceramic layer so that a plurality of phosphor ceramic elements are disposed in a direction perpendicular to the thickness direction of the substrate in spaced-apart relation; forming a cover layer containing an inorganic substance on the substrate so as to cover the surface of the phosphor ceramic element; and cutting the cover layer and the substrate in the thickness direction so as to include at least one of the phosphor ceramic elements.

In the method for producing a wavelength conversion member of the present invention, it is preferable that the forming step includes a step of applying, on the substrate, and curing a ceramic ink, or a curable resin composition containing a curable resin and at least one inorganic particle of inorganic oxide particles and metal particles.

In the method for producing a wavelength conversion member of the present invention, it is preferable that the removing step includes a step of scraping off a portion of the phosphor ceramic layer using a blade.

In the method for producing a wavelength conversion member of the present invention, it is preferable that the substrate is an easy-release sheet.

A wavelength conversion member of the present invention is produced by the above-described production method.

### EFFECT OF THE INVENTION

The method for producing a wavelength conversion member of the present invention allows for easy and industrial production of a wavelength conversion member including a phosphor ceramic element and a cover layer covering the surface thereof.

The wavelength conversion member of the present invention produced by the production method of the present invention has excellent heat resistance.

### BRIEF DESCRIPTION OF THE DRAWINGS

FIG. 1A to FIG. 1I are process diagrams in cross section illustrating a method for producing the wavelength conversion member of the present invention in an embodiment,
FIG. 1A illustrating a step of preparing a green sheet,
FIG. 1B illustrating a step of baking the green sheet,
FIG. 1C illustrating a step of disposing a phosphor ceramic layer on a substrate,
FIG. 1D illustrating a step of scraping off a portion of the phosphor ceramic layer,
FIG. 1E illustrating step of producing a phosphor ceramic element,
FIG. IF illustrating a step of forming a curable layer,
FIG. 1G illustrating a step of forming a cover layer,
FIG. 1H illustrating a step of cutting the cover layer and the substrate, and
FIG. 1I illustrating a step of producing a wavelength conversion member.
FIG. 2 shows a plan view of the step in FIG. 1E.
FIG. 3 shows a cross-sectional view of a semiconductor light-emitting device including the wavelength conversion member of the present invention in an embodiment.
FIG. 4A to FIG. 4E are process diagrams in cross section illustrating a method for producing the wavelength conversion member of the present invention in another embodiment (embodiment in which the phosphor ceramic element has a trapezoid shape when viewed in cross section),

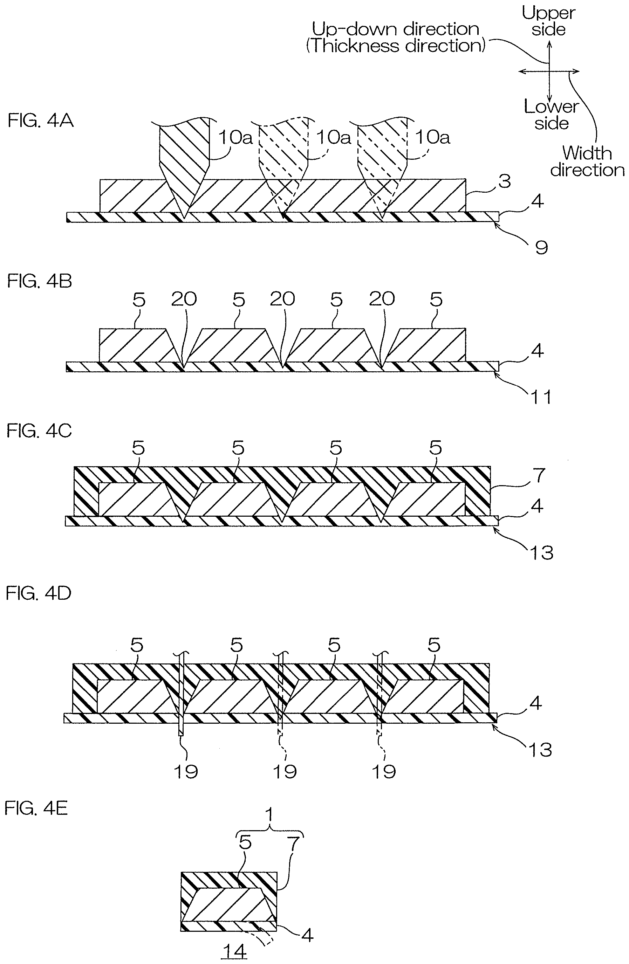

FIG. 4A illustrating a step of scraping off a portion of the phosphor ceramic layer,
FIG. 4B illustrating a step of producing a phosphor ceramic element,
FIG. 4C illustrating a step of forming a cover layer,
FIG. 4D illustrating a step of cutting the cover layer and the substrate, and
FIG. 4E illustrating a step of producing a wavelength conversion member.

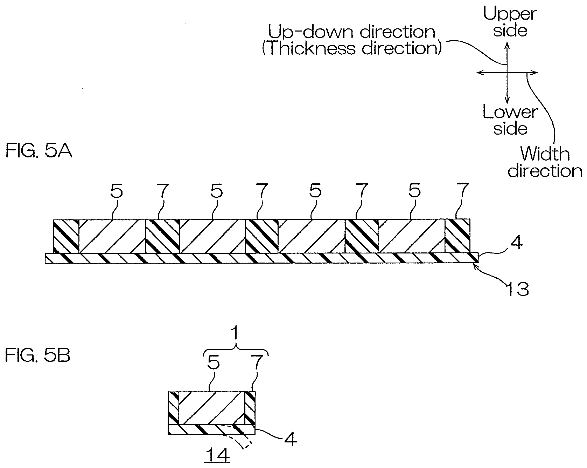

FIG. 5A and FIG. 5B are process diagrams in cross section illustrating a method for producing the wavelength conversion member of the present invention in another embodiment (embodiment in which only the side face of the phosphor ceramic element is covered with the cover layer),
FIG. 5A illustrating a step of forming a cover layer, and
FIG. 5B illustrating a step of producing a wavelength conversion member.

### [DESCRIPTION OF EMBODIMENTS]

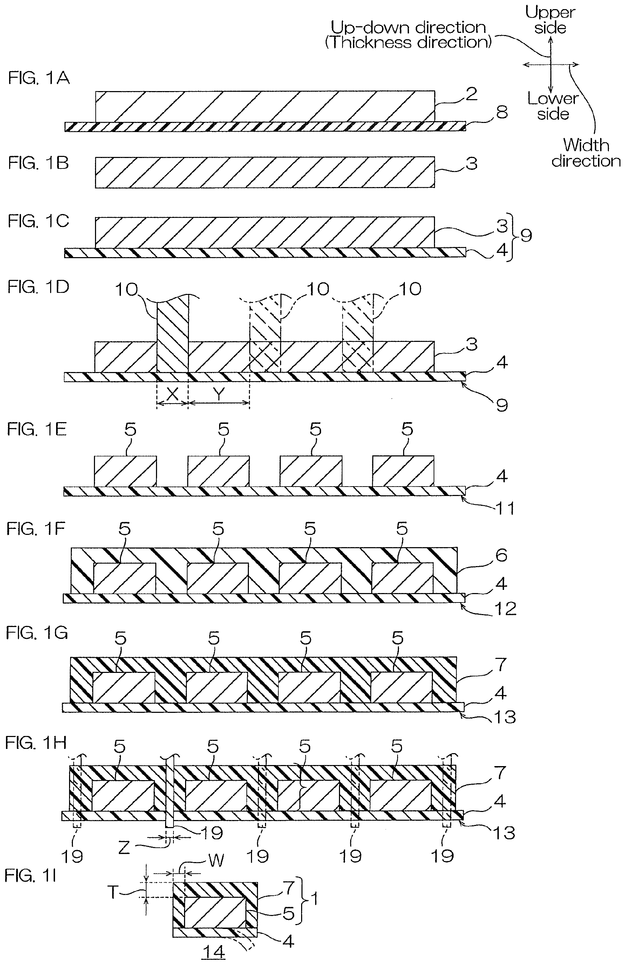

A method for producing a wavelength conversion member 1 is described with reference to FIG. 1A to FIG. 1I.

The up-down direction on the plane of the sheet in FIG. 1A to FIG. 1I is referred to as "up-down direction" (first direction, thickness direction), the upper side on the plane of the sheet is upper side, and the lower side on the plane of the sheet is lower side. The left-right direction on the plane of the sheet of FIG. 1A to FIG. 1I is referred to as "width direction" (second direction, left-right direction, the direction perpendicular to the first direction), the right direction on the plane of the sheet is right side, and the left direction on the plane of the sheet of FIG. 1A to FIG. 1I is left side. The paper thickness direction of FIG. 1A to FIG. 1I is referred to as "front-back direction" (third direction, direction perpendicular to the first direction and the second direction), the near side of the paper thickness direction of FIG. 1A to FIG. 1I is front side, and the far side of the paper thickness direction of FIG. 1A to FIG. 1I is back side. In Figures other then FIG. 1A to FIG. 1I, the directions are based on the directions in FIG. 1A to FIG. 1I.

A method for producing a wavelength conversion member 1 includes preparing a green sheet 2, baking the green sheet 2, disposing a phosphor ceramic layer 3 on a substrate 4, scraping off a portion of the phosphor ceramic layer 3, producing a phosphor ceramic element 5, forming a curable layer 6, forming a cover layer 7, cutting the cover layer 7 and the substrate 4, and producing a wavelength conversion member 1.

First, as shown in FIG. 1A, a green sheet 2 is prepared (preparation step). The green sheet 2 is formed by applying and drying a slurry containing, for example, a phosphor material, a binder resin, and a solvent on the upper face of a release sheet 8.

The phosphor material is a raw material composing the phosphor described later, and is prepared by suitably selecting from examples thereof including, for example, aluminum oxide, yttrium oxide, cerium oxide, zirconium oxide, titanium oxide, and furthermore, those materials added with other elements for activation.

For the binder resin, a known binder resin used for production of the green sheet 2 can be used, and examples thereof include acrylic polymer, butyral polymer, vinyl polymer, and urethane polymer. Preferably, acrylic polymer is used.

The binder resin content relative to a total volume amount of the phosphor material and binder resin is, for example, 5% by volume or more, preferably 20% by volume or more, and 80% by volume or less, preferably 60% by volume or less.

Examples of the solvent include water, and organic solvents such as acetone, methyl ethyl ketone, methanol, ethanol, toluene, methyl propionate, and methylcellsolve.

The solvent content in the slurry is, for example, 1 to 30 mass%.

For the slurry, as necessary, known additives such as a dispersing agent, a plasticizer, and a sintering auxiliary agent can be added.

Then, the above-described components are blended at the above-described ratio, and the mixture is subjected to wet blending with a ball mill, thereby preparing a slurry.

Then, the slurry is applied on the upper face of the release sheet 8 by known application methods such as doctor blade, gravure coater, fountain coater, cast coater, spin coater, and roll coater, and dried, thereby forming the green sheet 2.

Examples of the release sheet 8 include resin films such as polyester films including a polyethylene terephthalate (PET) film; a polycarbonate film; polyolefin films including a polyethylene film and a polypropylene film; a polystyrene film; an acrylic film; a silicone resin film; and a fluorine resin film. Furthermore, metal foils such as copper foil and stainless steel foil can be used. Preferably, a resin film, even more preferably, a polyester film is used.

The surface of the release sheet 8 is subjected to, as necessary, release treatment to improve release properties.

The release sheet 8 has a thickness of, for example, 10 to 200 µm, in view of handleability and costs.

The thus produced green sheet 2 is ceramics before sintering of the phosphor ceramic layer 3 (phosphor ceramic plate), and is formed into a generally rectangular flat plate shape when viewed from the top.

The green sheet 2 can also be formed by laminating a plurality of (a plurality of layers) green sheets 2 by heat lamination to obtain a desired thickness.

The green sheet 2 has a thickness of, for example, 10 µm or more, preferably 30 µm or more, and for example, 500 µm or less, preferably 200 µm or less.

Then, as shown in FIG. 1B, the green sheet 2 is baked (baking step).

The baking temperature is, for example, 1300°C or more, preferably 1500°C or more, and for example, 2000°C or less, preferably 1800°C or less.

The baking time is, for example, 1 hour or more, preferably 2 hours or more, and for example, 24 hours or less, preferably 5 hours or less.

The baking can be performed under normal pressure, under reduced pressure, or under vacuum.

Before the above-described baking (main baking), to thermally decompose and remove the organic component such as a binder resin and a dispersing agent, de-binder processing can be performed by using an electric furnace in air by preheating at, for example, 600 to 1300°C.

The speed of temperature increase in baking is, for example, 0.5 to 20°C/min.

The phosphor ceramic layer 3 is produced in this manner.

The thus produced phosphor ceramic layer 3 is formed into a generally rectangular flat plate shape when viewed from the top.

The phosphor ceramic layer 3 has a thickness of, for example, 10 µm or more, preferably 50 µm or more, and for example, 500 µm or less, preferably 200 µm or less.

Then, as shown in FIG. 1C, the phosphor ceramic layer 3 is disposed on the substrate 4 (disposing step). To be specific, the phosphor ceramic layer 3 is disposed on a generally center portion of the upper face of the substrate 4.

For the substrate 4, in view of scraping off of the blade (described later), and removal of the substrate 4 from the wavelength conversion member 1, preferably, an easy-release sheet is used. The easy-release sheet is formed, for example, by a thermal release sheet that can be released easily by heat.

The thermal release sheet includes a support layer, and a pressure-sensitive adhesive layer laminated on the upper face of the support layer.

The support layer is formed, for example, from a heat resistance resin such as polyester.

The pressure-sensitive adhesive layer has tackiness at, for example, normal temperature (25°C), and is formed from a thermal expansion adhesive whose tackiness decreases when heated (or loses adhesiveness).

For the thermal release sheet, a commercially available product can be used, and to be specific, REVALPHA series (registered trademark, manufactured by Nitto Denko Corporation) may be used.

The thermal release sheet is released from the wavelength conversion member 1, based on reduction of tackiness of the pressure-sensitive adhesive layer by heat, while reliably supporting, by the support layer, the phosphor ceramic layer 3 (and the wavelength conversion member 1) through the pressure-sensitive adhesive layer.

The substrate 4 can be formed from resin materials including vinyl polymers such as polyolefin (to be specific, polyethylene, polypropylene) and ethylene-vinyl acetate copolymer (EVA); polyesters such as polyethylene terephthalate and polycarbonate; and fluorine resin such as polytetrafluoroethylene. The substrate can be formed from, for example, metal materials such as iron, aluminum, and stainless steel.

The substrate 4 has a thickness of, for example, 10 to 1000 µm.

The ceramic laminate 9 including the substrate 4 and the phosphor ceramic layer 3 provided on the upper face of the substrate 4 is produced in this manner.

Then, as shown in FIG. 1D, a portion of the phosphor ceramic layer 3 is removed (removing step). To be specific, a portion of the phosphor ceramic layer 3 is scraped off by using a dicing blade 10 such as a blade.

The dicing blade 10 is a disc rotary blade used for a known or commercially available dicing device. The distal end (lower end) of the dicing blade 10 is formed to be a generally rectangular shape (plate) extending in up-down direction when projected in the direction along the cutting direction (in FIG. 1D, paper thickness direction, i.e., front-back direction). That is, it is formed so that the cutting plane is a generally rectangular shape.

The dicing blade 10 has a width direction length X at the distal end of, for example, 0.05 mm or more, preferably 0.1 mm or more, and for example, 2.0 mm or less, preferably 1.0 mm or less.

In this step, first, as shown in FIG. 1D, a portion of the phosphor ceramic layer 3 is scraped off along the front-back direction.

To be specific, the ceramic laminate 9 is disposed inside the dicing device so that the cutting direction is front-back direction. Then, the positions of the dicing blade 10 or the ceramic laminate 9 are arranged so that when moving the dicing blade 10, the distal end (lower end) of the dicing blade 10 is in contact with the phosphor ceramic layer 3, and does not penetrate the substrate 4. That is, the position of the dicing blade 10 or the ceramic laminate 9 in up-down direction is adjusted so that the distal end of the dicing blade 10 reaches the upper face of the substrate 4, and does not reach the lower face of the substrate 4. Then, while rotating the dicing blade 10 at a high speed, the dicing blade 10 is moved in front-back direction along the cutting direction.

In this manner, the portion of the phosphor ceramic layer 3 contacting the dicing blade 10 (periphery of distal end) is scraped off from the substrate 4 along front-back direction. That is, the phosphor ceramic layer 3 is scraped off into a generally rectangular shape. At the portion scraped off, the upper face of the substrate 4 is exposed.

The scraping off in front-back direction is repeatedly performed, as shown in the phantom line in FIG. 1D, with a desired interval (that is, desired width direction length of the phosphor ceramic element 5).

Then, in the same manner as described above, while rotating the dicing blade 10 at a high speed, the dicing blade 10 is moved so that the cutting direction is along the width direction, thereby scraping off a portion of the phosphor ceramic layer 3 in the width direction. The scraping off in the width direction is repeatedly performed with a desired interval.

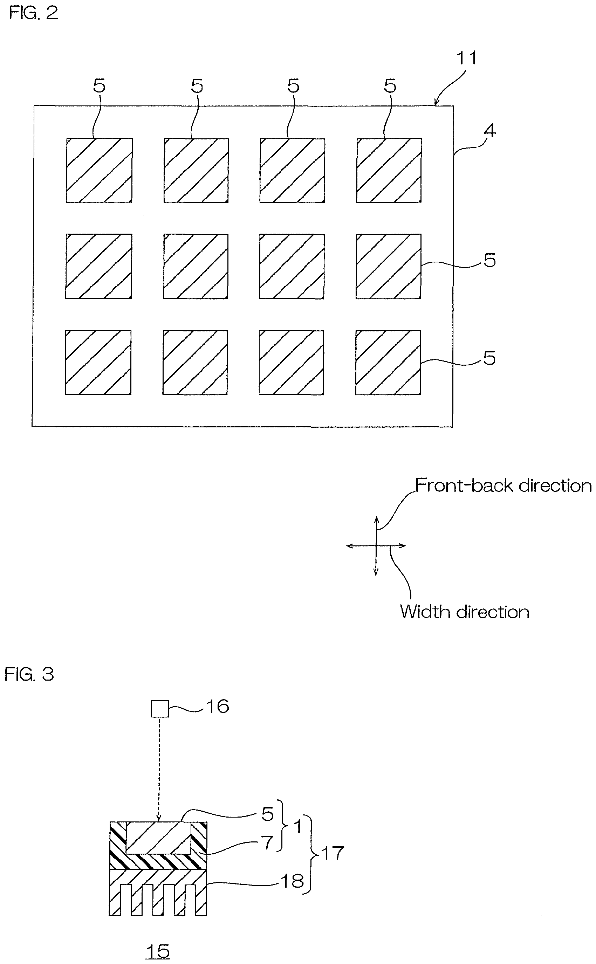

That is, as shown in FIG. 2, the phosphor ceramic layer 3 is scraped off like a grid.

In this manner, as shown in FIG. 1E and FIG. 2, an element-disposed substrate 1l including a substrate 4, and a plurality of phosphor ceramic elements 5 arranged in line like a grid on the upper face of the substrate 4 is produced.

In the above-described step, a portion of the phosphor ceramic layer 3 is scraped off by fixing the phosphor ceramic layer 3 and moving the dicing blade 10. However, for example, the position of the dicing blade 10 rotating at a high speed can be fixed, and by moving the ceramic laminate 9 relative to the dicing blade 10 with, for example, an X-Y stage, in front-back direction or width direction, a portion of the phosphor ceramic layer 3 can be scraped off.

The phosphor ceramic element 5 is formed into a generally rectangular shape when viewed in cross section and a generally rectangular shape when viewed from the top.

The width direction length Y of the phosphor ceramic element 5 is, for example, 0.2 mm or more, preferably 1.0 mm or more, and for example, 10 mm or less, preferably 5 mm or less. The front-back direction length of the phosphor ceramic element 5 is, for example, 0.05 mm or more, preferably 0.1 mm or more, and for example, 5 mm or less, preferably 3 mm or less.

The width direction interval and the front-back direction interval of the plurality of phosphor ceramic elements 5 are the same as the width direction length X of the distal end of the dicing blade 10.

Then, as shown in FIG. IF and FIG. 1G, the cover layer 7 containing the inorganic substance is formed on the substrate 4 so as to cover the surface of the phosphor ceramic element 5 (forming step).

In the forming step, first, as shown in FIG. IF, a curable composition containing the inorganic substance is applied on the substrate 4 by a known method so as to cover the upper face and the side face of the phosphor ceramic element 5, thereby forming the curable layer 6 (curable layer forming step).

For the curable composition, those containing an inorganic substance and is curable are used without limitation. Examples of the curable composition include a ceramic ink; a curable resin composition containing a curable resin and inorganic particles; and an aqueous silicate solution containing alkali metal silicate and inorganic particles.

The ceramic ink contains, for example, inorganic ceramics, a binder such as organopolysiloxane, and a solvent, and is cured (solidified) at a low temperature (e.g., 120 to 180°C). Examples of the inorganic substance in the ceramic ink include white pigments such as silicon dioxide, titanium dioxide, and potassium titanate. Examples of the solvent include ethers such as butyldiglycolether and diethylene glycoldibutylether. In view of dispersiveness, white pigment is preferably subjected to surface treatment.

For the ceramic ink, a commercially available product can be used, and to be specific, examples thereof include ceramic inks manufactured by AIN Co., Ltd. (TYPE RG, TYPE AN, TYPE UV, and TYPE SD).

Examples of the curable resin contained in the curable resin composition include a curable silicone resin, an epoxy resin, and an acrylic resin. Preferably, a curable silicone resin is used.

Examples of the curable silicone resin include condensation reaction curable silicone resin, and addition reaction curable silicone resin. Preferably, an addition reaction curable silicone resin is used.

The addition reaction curable silicone resin is composed of a silicone resin composition containing, for example, an ethylene-based unsaturated hydrocarbon group-containing polysiloxane as a main component, and an organo hydrogen siloxane as a cross-linking agent. The addition reaction curable silicone resin is generally provided as two components of liquid A containing a main component (ethylene-based unsaturated hydrocarbon group-containing polysiloxane), and liquid B containing a cross-linking agent (organo hydrogen siloxane). Then, the main component (liquid A) and the cross-linking agent (liquid B) are mixed and a mixture is prepared, and in a step of forming the cover layer 7 from the mixture, the ethylene-based unsaturated hydrocarbon group-containing polysiloxane and the organo hydrogen siloxane undergo addition reaction by heat, curing the addition reaction curable silicone resin to form silicone elastomer (cured product).

For the addition reaction curable silicone resin, a commercially available product (trade name: KER-2500, manufactured by Shin-Etsu Chemical Co., Ltd., trade name: LR-7665, manufactured by Wacker asahikasei silicone co.,ltd., etc.) may be used.

Examples of the inorganic substance composing the inorganic particles include inorganic oxides such as silicon dioxide, titanium dioxide, aluminum oxide, zirconium oxide, and titanic acid composite oxide (e.g., barium titanate, potassium titanate), and metals such as silver and aluminum. In view of light reflectivity and heat-releasing characteristics, preferably, titanium dioxide, aluminum oxide, zirconium oxide, barium titanate, and silver are used, and in view of long-term heat resistance, more preferably, titanium dioxide, aluminum oxide, zirconium oxide, and barium titanate are used, even more preferably, titanium dioxide and aluminum oxide are used.

The inorganic particles have an average particle size (average maximum length) of, for example, 0.1 to 50 µm.

For the curable resin composition, preferably used is a curable resin composition containing a curable silicone resin and inorganic particles composed of at least one selected from the group consisting of titanium dioxide, aluminum oxide, zirconium oxide, barium titanate, and silver; more preferably used is a curable resin composition containing a curable silicone resin and inorganic particles composed of at least one selected from the group consisting of titanium dioxide, aluminum oxide, zirconium oxide, and barium titanate; even more preferably used is a curable resin composition containing a curable silicone resin and inorganic particles composed of at least one of titanium dioxide and aluminum oxide.

Examples of the alkali metal silicate included in the aqueous silicate solution include sodium silicate (water glass).

The curable composition has an inorganic substance content (solid content) of, for example, 30 mass% or more, preferably 40 mass% or more, more preferably 60 mass% or more, and for example, 90 mass% or less, preferably 80 mass% or less. The curable composition has a binder or curable resin content (solid content) of, for example, 10 mass% or more, preferably 20 mass% or more, for example, 70 mass% or less, preferably 60 mass% or less, more preferably 40 mass% or less.

For the curable composition, preferably used are a ceramic ink and a curable resin composition containing a curable resin and at least one inorganic particle of inorganic oxide particles and metal particles; more preferably used are a ceramic ink and a curable resin composition containing a curable resin and inorganic oxide particles; even more preferably used is a ceramic ink. In this manner, heat-releasing characteristics and reflectivity of the cover layer 7 can be improved.

For the application method of the curable composition, a known application method such as printing and dispensing can be used.

In this manner, a curable layer-element laminate 12 including the substrate 4, the plurality of phosphor ceramic elements 5 arranged in line on the substrate 4, and the curable layer 6 formed on the substrate 4 so as to cover the upper face and the side face of the plurality of phosphor ceramic elements 5 is produced.

Then, as shown in FIG. 1G, the cover layer 7 is formed (cover layer forming step). To be specific, the curable layer 6 is cured (solidified) by heating, thereby forming the cover layer 7.

The heating temperature is, for example, 100°C or more, preferably 120°C or more, and for example, 200°C or less, preferably 180°C or less.

The heating time is, for example, 0.5 hours or more, preferably 1 hour or more, and for example, 12 hours or less, preferably 6 hours or less.

Furthermore, as necessary, before thermosetting, drying step can be conducted under conditions of, for example, 50 to 100°C, and 1 to 10 hours.

In this manner, the curable layer 6 is heated and cured, thereby forming the cover layer 7.

That is, the cover layer-element laminate 13 including the substrate 4, the plurality of phosphor ceramic elements 5 arranged in line on the substrate 4, and the cover layer 7 formed on the substrate 4 so as to cover the upper face and the side face of the plurality of phosphor ceramic elements 5 is produced.

Then, as shown in FIG. 1H, the cover layer 7 and the substrate 4 are cut in the thickness direction so as to include one phosphor ceramic element 5 (cutting step). That is, the plurality of phosphor ceramic elements 5 are cut so that the phosphor ceramic elements 5 are separated into individual pieces (individualized).

To be specific, the cover layer 7 and the substrate 4 are cut by using a narrow-width blade 19 by dicing between the phosphor ceramic elements 5 next to each other, along the thickness direction.

The narrow-width blade 19 is a blade having a narrower width than that of the dicing blade 10, and is a disc rotary blade used for a known or commercially available dicing device. The narrow-width blade 19 is formed into a generally rectangular shape (plate) extending in up-down direction when projected along the cutting direction (in FIG. 1H, paper thickness direction, i.e., front-back direction).

The narrow-width blade 19 has a width direction length Z that is smaller than the width direction length X of the dicing blade 10, and the width direction length Z is, for example, 80% or less, preferably 60% or less, and for example, 10% or more, preferably 30% or more of the width direction length X. To be specific, the width direction length Z is, for example, 0.01 mm or more, preferably 0.05 mm or more, and for example, 1.5 mm or less, preferably 0.8 mm or less.

In this cutting step, the cover layer-element laminate 13 is disposed in the dicing device. Then, the positions of the narrow-width blade 19 or the cover layer-element laminate 13 are adjusted so as to cut the cover layer 7 and the substrate 4 in the thickness direction. That is, the position of the narrow-width blade 19 or the cover layer-element laminate 13 in up-down direction is adjusted so that the distal end of the narrow-width blade 19 penetrates the cover layer 7 and reaches the lower face of the substrate 4. Then, in the same manner as in the above-described removing step, while rotating the narrow-width blade 19 at a high speed, the narrow-width blade 19 is moved in front-back direction and width direction between the phosphor ceramic elements 5 next to each other (that is, like a grid), thereby cutting the cover layer 7 and the substrate 4.

As shown in FIG. 1I, the substrate-laminated wavelength conversion member 14 including the substrate 4, the individualized phosphor ceramic element 5, and the cover layer 7 is produced in this manner.

Then, as shown in the phantom line of FIG. 1I, the substrate 4 is removed to produce the wavelength conversion member 1 including the individualized phosphor ceramic element 5 and the cover layer 7.

The phosphor ceramic element 5 is provided at a generally center of the upper face of the substrate 4 when viewed from the top, and is formed from ceramics (baked product) of the phosphor.

The phosphor contained in the phosphor ceramics has a wavelength conversion function, and examples thereof include yellow phosphor which can convert blue light to yellow light, and red phosphor which can convert blue light to red light.

Examples of yellow phosphor include silicate phosphor such as (Ba,Sr,Ca)₂SiO₄;Eu and (Sr,Ba)₂SiO₄: Eu (barium orthosilicate (BOS)); garnet phosphor having a garnet crystal structure such as Y₃Al₅O₁₂: Ce (YAG (yttrium aluminum garnet): Ce) and Tb₃Al₃O₁₂: Ce (TAG (terbium aluminum garnet): Ce); and oxynitride phosphor such as Ca-α-SiAlON. Examples of the red phosphor include nitride phosphor such as CaAlSiN₃: Eu and CaSiN₂: Eu.

The cover layer 7 is provided on the upper face of the substrate 4 so as to cover the surface of the phosphor ceramic element 5. To be specific, the cover layer 7 is provided on the upper face of the substrate 4 so as to cover the surface of the phosphor ceramic element 5 (upper face and side face), and the upper face of the substrate 4 (excluding the surface where the phosphor ceramic element 5 is disposed).

The cover layer 7 has a thickness (distance T from the upper face of the phosphor ceramic element 5 to the upper face of the cover layer 7 in FIG. 1I) of, for example, 10 µm or more, preferably 50 µm or more, and for example, 500 µm or less, preferably 200 µm or less.

The cover layer 7 has a side face width (distance W from the side face of the phosphor ceramic element 5 to the external surface of the cover layer 7 in FIG. 1I) of, for example, 10 µm or more, preferably 50 µm or more, and for example, 500 µm or less, preferably 200 µm or less.

The cover layer 7 is formed, as described above, from a composition containing an inorganic substance.

The cover layer 7 preferably works as a heat dissipation layer and a reflection layer.

The cover layer 7 has a thermal conductivity of more than 0.20 W/m·K, preferably 1.0 W/m·K or more, more preferably 3.0 W/m·K or more, and for example, 30.0 W/m·K or less. The thermal conductivity can be determined by a xenon flash analyzer (manufactured by NETZSCH, LFA 447).

The cover layer 7 has a reflectivity of, for example, 80% or more, preferably 90% or more, and for example, 100% or less. The reflectivity can be determined by measuring reflection of light with a wavelength of 450 nm using an ultraviolet-visible spectrophotometer ("V 670", manufactured by JASCO Corporation).

The wavelength conversion member 1 can be used for, for example, semiconductor light-emitting devices (e.g., light-emitting diode device, semiconductor laser device) for far-reaching application including a high output light source such as lighting for vehicles, pendant lights, road lights, and stage lighting products.

To be specific, as shown in FIG. 3, the semiconductor light-emitting device 15 includes the light source 16 and the wavelength conversion heat dissipation member 17.

Examples of the light source 16 include a light-emitting diode (LED) and a semiconductor laser (LD).

The wavelength conversion heat dissipation member 17 is disposed to face the light source 16 in spaced-apart relation, and includes the wavelength conversion member 1 and the heat dissipation member 18.

The heat dissipation member 18 is provided on the surface (lower face) of the cover layer 7 of the wavelength conversion member 1. The heat dissipation member 18 is formed to be a generally rectangular flat plate shape when viewed from the top, and on the lower face thereof, a plurality of projections for improving heat-releasing characteristics are provided toward the lower side. The heat dissipation member 18 is, for example, a heat sink, and is formed from thermal conductive metals such as aluminum and copper, and a ceramic material such as A1N. The heat dissipation member 18 allows for heat dissipation of heat generated in the wavelength conversion member 1 to the outside.

The wavelength conversion heat dissipation member 17 is produced by allowing a heat dissipation member 18 to adhere to the surface of the cover layer 7 of the wavelength conversion member 1 with a known thermal conductive adhesive layer (not shown), and then removing the substrate 4 from the cover layer 7 and the phosphor ceramic element 5 by, for example, heating.

In the wavelength conversion member 1, the phosphor layer is formed from the phosphor ceramic element 5, and therefore excellent heat resistance and heat-releasing characteristics can be achieved.

Furthermore, the cover layer 7 covering the phosphor ceramic element 5 contains inorganic substance, and therefore heat generated in the phosphor ceramic element 5 can be conducted efficiently to the outside through the cover layer 7, achieving excellent heat-releasing characteristics. Furthermore, the light diffused and radiated at the phosphor ceramic element 5 can be efficiently reflected.

In the method for producing a wavelength conversion member 1, the wavelength conversion member 1 including the phosphor ceramic element 5 separated into individual pieces and having excellent heat resistance, heat-releasing characteristics, and reflectivity can be produced easily and industrially.

### (Modified Example)

In the following Figures, for the members corresponding to the above-described members, the same reference numerals are given and detailed descriptions thereof are omitted.

In the embodiment of FIG. 1D, the portion of the phosphor ceramic layer 3 is scraped off using the dicing blade 10 having a generally rectangular shape when viewed in cross section; however, for example, the portion of the phosphor ceramic layer 3 can be scraped off, as shown in FIG. 4A, using a dicing blade 10a having a distal end with a generally triangular shape when viewed in cross section.

To be specific, as shown in FIG. 4A, the dicing blade 10a or the ceramic laminate 9 is disposed so that when the triangular dicing blade 10a is moved, the distal end of the dicing blade 10a penetrates the phosphor ceramic layer 3 and reaches inside the substrate 4. To be specific, the position of the dicing blade 10 or the ceramic laminate 9 in up-down direction is adjusted so that the distal end of the dicing blade 10a reaches the upper face of the substrate 4, and does not reach the lower face of the substrate 4.

Then, the triangular dicing blade 10a is moved in front-back direction, thereby scraping off the phosphor ceramic layer 3 contacting the triangular dicing blade 10a from the upper face of the substrate 4.

Then, in the same manner as described above, the triangular dicing blade 10a is moved in width direction, thereby scraping off the portion of the phosphor ceramic layer 3 from the substrate 4. That is, the phosphor ceramic layer 3 is scraped off like a grid.

In this manner, as shown in FIG. 4B, the element-disposed substrate 11 including the substrate 4 and the plurality of phosphor ceramic elements 5 arranged in line like a grid on the substrate 4 is produced.

The phosphor ceramic element 5 produced in FIG. 4B is formed into a generally trapezoid shape decreasing its width toward the upper side when viewed in cross section. On the upper face of the substrate 4, a triangular recess portion 20 corresponding to the distal end shape of the triangular dicing blade 10a is formed.

Then, in the same manner as in the steps shown in FIG. IF and FIG. 1G, as shown in FIG. 4C, the cover layer 7 is formed so as to cover the upper face and the side face of the phosphor ceramic element 5, thereby producing the cover layer-element laminate 13.

Then, in the same manner as in the step shown in FIG. 1H, as shown in FIG. 4D, the cover layer 7 and the substrate 4 are cut in the thickness direction using a narrow-width blade 19 so as to include one phosphor ceramic element 5.

A narrow-width blade 19 having a width direction length shorter than the width direction length of the recess portion 20 is used.

As shown in FIG. 4E, the wavelength conversion member 1 including the phosphor ceramic element 5 separated into individual pieces and having a trapezoid shape when viewed in cross section, and the cover layer 7 is produced in this manner.

The embodiment of FIG. 4A to FIG. 4E also has the same operations and effects as in the embodiment of FIG. 1A to FIG. 1I.

In the embodiment of FIG. 1G, the cover layer 7 is formed to cover the upper face and the side face of the phosphor ceramic element 5; however, for example, as shown in FIG. 5A, the cover layer 7 can also be formed so as to cover only the side face of the phosphor ceramic element 5.

That is, the cover layer 7 is formed so as not to cover the upper face of the phosphor ceramic element 5 but to cover the entire side face of the phosphor ceramic element 5. The cover layer 7 is formed so that the upper face of the cover layer 7 is flush with the upper face of the phosphor ceramic element 5.

Then, in the same manner as in the step shown in FIG. 1H, the cover layer 7 and the substrate 4 are cut in the thickness direction so as to include one phosphor ceramic element 5 as shown in FIG. 5B, thereby producing the wavelength conversion member 1 including the phosphor ceramic element 5 separated into individual pieces.

The wavelength conversion member 1 includes the phosphor ceramic element 5 having its upper face exposed, and the cover layer 7 covering the side face of the phosphor ceramic element 5.

The embodiment of FIG. 5A to FIG. 5B has the same operations and effects as in the embodiment of FIG. 1A to FIG. 1I.

In FIG. 1H, the portion of the phosphor ceramic layer 3 is scraped off by using one dicing blade 10; however, for example, although not shown, the portion of the phosphor ceramic layer 3 can also be simultaneously scraped off by using a plurality of dicing blades 10. That is, the plurality of dicing blades 10 are disposed in spaced-apart relation in width direction or front-back direction, and while rotating the plurality of dicing blades at a high speed, the plurality of dicing blades 10 or the ceramic laminate 9 can be moved simultaneously.

Furthermore, in FIG. 1I, the cover layer 7 and the substrate 4 are cut so as to include one phosphor ceramic element 5; however, for example, although not shown, the cover layer 7 and the substrate 4 can also be cut so as to include two or more phosphor ceramic elements 5.

### [Examples]

In the following, the present invention is described in further detail with reference to Examples. However, the present invention is not limited to these. The specific numeral values such as mixing ratio (content), physical property values, and parameters used in the description below can be replaced with the upper limit value (numeral values defined with "or less", "less than") or the lower limit value (numeral values defined with "or more", "more than") of the corresponding mixing ratio (content), physical property values, parameters in the above-described "DESCRIPTION OF EMBODIMENTS".

A phosphor material powder composed of 11.34 g of yttrium oxide particles (purity 99.9%, manufactured by Nippon yttrium co., ltd.), 8.577 g of aluminum oxide particles (purity 99.9%, manufactured by Sumitomo Chemical Co., Ltd.), and 0.087 g of cerium oxide particles was prepared.

20 g of the phosphor material powder prepared was mixed with water soluble binder resin ("WB 4101", manufactured by Polymer Innovations, Inc.) so that the solid content volume ratio was 60: 40, and furthermore, distilled water was added. The mixture was put into an alumina-made vessel, zirconia balls having a diameter of 3 mm were added, and the mixture was subjected to wet blending with a ball mill for 24 hours, thereby preparing a slurry of phosphor material particles.

Then, the prepared slurry was tape-casted on a PET film 8 as a release sheet by doctor blade method and dried, thereby forming a green sheet 2 having a thickness of 75 µm (ref: FIG. 1A). Thereafter, the green sheet 2 was removed from the PET film 8, and the green sheet 2 was cut into a size of 20 mm × 20 mm. Two sheets of the green sheet 2 that was cut were prepared, and the two green sheets 2 were heat laminated using a hot press, thereby preparing the green sheet laminate 2.

Then, the prepared green sheet laminate 2 was heated in an electric muffle furnace in air at a temperature increase speed of 1°C/min to 1200°C, and de-binder processing was performed, in which an organic component such as binder resin is decomposed and removed. Thereafter, the green sheet laminate 2 was transferred to a high temperature vacuum furnace, and heated under reduced pressure of about 10⁻³Torr (about 0.13Pa) and a temperature increase speed of 5°C/min to 1750°C. The baking was performed at that temperature for 3 hours, thereby producing a phosphor ceramic layer 3 (phosphor ceramic plate) having a thickness of 120 µm and composed of Y₃Al₅O₁₂: Ce (ref: FIG. 1B).

Then, the phosphor ceramic layer 3 was bonded to the pressure-sensitive adhesive layer side (upper face) of the thermal release sheet 4 (substrate, trade name "REVALPHA 31950", manufactured by Nitto Denko Corporation) set on the dicing frame of the dicing device (trade name "Dicing saw", manufactured by DISCO Corporation), thereby producing a ceramic laminate 9 (ref: FIG. 1C).

Then, the position in up-down direction of the dicing blade 10 (distal end width X: 0.4 mm) having a distal end with a generally rectangular shape when viewed in cross section was adjusted so that the distal end of the dicing blade 10 coincided with the upper face of the thermal release sheet 4.

Then, while rotating the dicing blade 10 at a high speed, the dicing blade 10 was moved relative to the ceramic laminate 9 so that the width direction interval (Y) and front-back direction interval were 3.0 mm, thereby scraping off a portion of the phosphor ceramic layer 3 into a grid-like form (ref: FIG. 1D).

In this manner, an element-disposed substrate 11 was produced. In the element-disposed substrate 11, a plurality of phosphor ceramic elements 5 (3.0 mm × 3.0 mm) were arranged in line in spaced-apart relation with an interval of 0.4 mm in front-back direction and width direction like a grid on the thermal release sheet 4 (ref: FIG. 1E and FIG. 2).

Then, a ceramic ink (trade name "RG 12-22", white, manufactured by AIN Co., Ltd.) was prepared as the material of the curable layer 6, and applied so as to cover the upper face and the side face of the phosphor ceramic element 5 with a doctor blade, thereby forming a curable layer 6. In this manner, a curable layer-element laminate 12 was produced (ref: FIG. 1F).

Then, the curable layer-element laminate 12 was dried at 90°C for 5 hours, and thereafter, thermal curing was conducted at 150°C for 2 hours, thereby forming a cover layer 7 (thickness 100 µm). In this manner, the cover layer-element laminate 13 was produced (ref: FIG. 1G).

Then, the cover layer-element laminate 13 was disposed in the dicing device. Thereafter, using a narrow-width blade 19 (distal end width Z: 0.2 mm) having a distal end with a generally rectangular shape when viewed in cross section, the center in the width direction and the center in the front-back direction between the phosphor ceramic elements 5 were cut so as to penetrate the cover layer 7 and the thermal release sheet 4 in the thickness direction (ref: FIG. 1H). That is, the cover layer-element laminate 13 was cut to give a size of 3.2 mm × 3.2 mm. The phosphor ceramic elements 5 were separated into individual pieces, and a substrate-laminated wavelength conversion member 14 was produced in this manner.

Then, the thermal release sheet 4 was removed at 200°C from the substrate-laminated wavelength conversion member 14. In this manner, a wavelength conversion member 1 having one phosphor ceramic element 5 (3.0 mm × 3.0 mm, thickness 120 µm) and cover layer 7 (3.2 mm × 3.2 mm, side face width W: 0.1 mm, thickness T: 100 µm) was made (ref: FIG. 1I).

While the illustrative embodiments of the present invention are provided in the above description, such is for illustrative purpose only and it is not to be construed as limiting in any manner. Modification and variation of the present invention which will be obvious to those skilled in the art are to be covered in the following claims.

### Industrial Applicability

The wavelength conversion member and production method thereof of the present invention can be applied to various industrial products, and for example, can be used for semiconductor light-emitting devices such as white light-emitting diode devices.

### [Description of reference numeral]

- 1: wavelength conversion member
- 3: phosphor ceramic layer
- 4: substrate
- 5: phosphor ceramic element
- 7: cover layer
- 10: dicing blade

## Claims

1. A method for producing a wavelength conversion member, the method comprising the steps of:
disposing a phosphor ceramic layer on a substrate,
removing a portion of the phosphor ceramic layer so that a plurality of phosphor ceramic elements are disposed in a direction perpendicular to the thickness direction of the substrate in spaced-apart relation,
forming a cover layer containing an inorganic substance on the substrate so as to cover the surface of the phosphor ceramic element, and
cutting the cover layer and the substrate in the thickness direction so as to include at least one of the phosphor ceramic elements.

2. The method for producing a wavelength conversion member according to Claim 1, wherein the forming step includes a step of applying, on the substrate, and curing
a ceramic ink, or
a curable resin composition containing a curable resin and at least one inorganic particle of inorganic oxide particles and metal particles.

3. The method for producing a wavelength conversion member according to Claim 1, wherein the removing step includes a step of scraping off a portion of the phosphor ceramic layer using a blade.

4. The method for producing a wavelength conversion member according to Claim 1, wherein the substrate is an easy-release sheet.

5. A wavelength conversion member produced by the method according to Claim 1.
